# EUROPEAN PATENT APPLICATION

(11) **EP 4 797 721 A1**
(43) Date of publication of application: **26.08.2026**
(21) Application number: 24934360.9
(22) Date of filing: 24.12.2024
(51) Int. Cl.: H04R 1/10

(54) **EARPHONE**

(71) Applicant: Shenzhen Shokz Co., Ltd., Shenzhen, Guangdong 518108 (CN)
(72) Inventor: WANG, Chu, Shenzhen, Guangdong 518108 (CN); XIE, Jianhua, Shenzhen, Guangdong 518108 (CN); ZHAO, Tao, Shenzhen, Guangdong 518108 (CN); XU, Jiang, Shenzhen, Guangdong 518108 (CN); ZHANG, Jiaming, Shenzhen, Guangdong 518108 (CN)
(74) Representative: Wang, Bo
(86) International application number: PCT/CN2024/141928
(87) International publication number: WO 2026/137194

(57) **Abstract**

The present disclosure discloses an earphone, relating to the technical field of electronic devices. The earphone comprises an antenna assembly and a capacitive detection component disposed within a radiation range of the antenna assembly. The capacitive detection component is configured to generate an electrical signal based on whether a user is wearing the earphone or whether the user performs a touch action. The capacitive detection component includes a detection electrode layer and a reference electrode layer stacked together. At least one of the detection electrode layer or the reference electrode layer includes a serpentine trace, and at least a portion of the serpentine trace is disposed in an overlapping region of the detection electrode layer and the reference electrode layer in a stacking direction. The present disclosure provides an improvement to the capacitive detection module, reducing its impact on the antenna assembly and enhancing antenna efficiency.

## Description

### TECHNICAL FIELD

The present disclosure relates to the technical field of electronic devices, and in particular, to earphones.

### BACKGROUND

Earphones have a relatively compact structure, and there are multiple ways of controlling the earphones, thereby enabling the earphones to provide various functions. However, during the research and development process, the inventors of this application discovered that the antenna efficiency in earphones has certain shortcomings.

### SUMMARY

The present disclosure provides an earphone. The earphone comprises an antenna assembly and a capacitive detection component disposed within a radiation range of the antenna assembly. The capacitive detection component is configured to generate an electrical signal based on whether a user is wearing the earphone or whether the user performs a touch action. The capacitive detection component includes a detection electrode layer and a reference electrode layer stacked together. At least one of the detection electrode layer or the reference electrode layer includes a serpentine trace, and at least a portion of the serpentine trace is disposed in an overlapping region of the detection electrode layer and the reference electrode layer in a stacking direction.

### BRIEF DESCRIPTION OF THE DRAWINGS

To more clearly illustrate the technical solutions of the embodiments of the present disclosure, a brief description of the drawings required for the description of the embodiments is provided below. It is apparent that the drawings described below are merely some embodiments of the present disclosure, and for those of ordinary skill in the art, other drawings may also be obtained based on these drawings without inventive effort.
FIG. 1 is a schematic diagram illustrating a partial structure of an earphone according to some embodiments of the present disclosure;
FIG. 2 is a block diagram illustrating the earphone shown in FIG. 1 according to some other embodiments of the present disclosure;
FIG. 3 is a block diagram illustrating a capacitive detection component of the earphone shown in FIG. 1 according to some embodiments of the present disclosure;
FIG. 4 is a block diagram illustrating a capacitive detection component of the earphone shown in FIG. 1 according to some embodiments of the present disclosure;
FIG. 5 is a schematic diagram illustrating a partial structure of the capacitive detection component shown in FIG. 3 according to some embodiments of the present disclosure;
FIG. 6 is a schematic diagram illustrating a partial structure of the capacitive detection component shown in FIG. 3 according to some embodiments of the present disclosure;
FIG. 7 is a schematic diagram illustrating a partial structure of the capacitive detection component shown in FIG. 3 according to some embodiments of the present disclosure;
FIG. 8 is a schematic diagram illustrating a partial structure of the capacitive detection component shown in FIG. 3 according to some embodiments of the present disclosure;
FIG. 9 is a schematic diagram illustrating a partial structure of the capacitive detection component shown in FIG. 3 according to some embodiments of the present disclosure;
FIG. 10 is a schematic diagram illustrating a partial structure of the capacitive detection component shown in FIG. 3 according to some embodiments of the present disclosure;
FIG. 11 is a schematic diagram illustrating a partial structure of the capacitive detection component shown in FIG. 3 according to some embodiments of the present disclosure;
FIG. 12 is a schematic diagram illustrating an earphone worn by a user according to some embodiments of the present disclosure.
FIG. 13 is schematic diagram illustrating the earphone shown in FIG. 12 from one perspective;
FIG. 14 is a schematic diagram illustrating the earphone shown in FIG. 12 from another perspective;
FIG. 15 is a schematic diagram illustrating a partial structure of an abutting portion shown in FIG. 14 according to some embodiments of the present disclosure;
FIG. 16 is a schematic diagram illustrating a first circuit board, a second circuit board, and a capacitive detection component shown in FIG. 15 according to some embodiments of the present disclosure.

### DETAILED DESCRIPTION

The present disclosure will be further described in detail below with reference to the accompanying drawings and embodiments. It should be noted that the following embodiments are merely intended to illustrate the present disclosure but not to limit its scope. Likewise, the following embodiments are only part of the embodiments of the present disclosure and not exhaustive thereof. All other embodiments obtained by a person of ordinary skill in the art without creative efforts shall fall within the scope of protection of the present disclosure.

The terms such as "an embodiment," "one embodiment," and "some embodiments" in present disclosure implies that the specific features, structures, or characteristics described in connection with the embodiments may be included in at least one embodiment of the present disclosure. Those skilled in the art may understand, both explicitly and implicitly, that the embodiments described herein may be combined with other embodiments.

The present disclosure describes an earphone. In some embodiments, the earphone may be an ear-clip earphone or an ear-hook earphone. In some embodiments, the earphone may be an in-ear earphone or a non-in-ear earphone. In some embodiments, the earphone may be a bone-conduction earphone or an air-conduction earphone. The bone-conduction earphone utilizes bone to propagate sound, which is different from the air-conduction earphone that transmits a sound wave to an eardrum through air. The bone-conduction earphone may directly transmit a sound vibration to an inner ear through the skull, thereby bypassing an outer ear and a middle ear and directly stimulating an auditory nerve of the inner ear. It may be understood that the earphone may also be an earphone obtained by combining any two types of the above-mentioned earphones according to a reasonable logic.

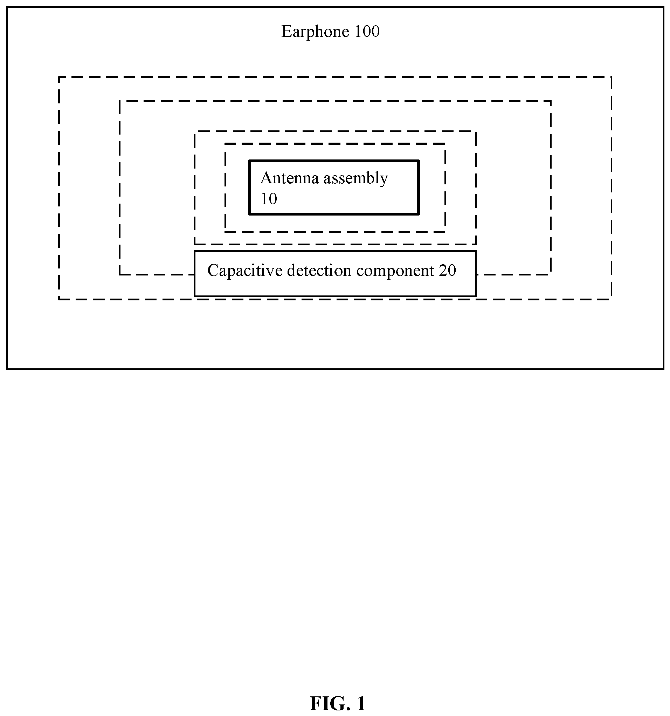

Please refer to FIG. 1, FIG. 1 is a schematic diagram illustrating a partial structure of an earphone according to some embodiments of the present disclosure. The earphone 100 may include an antenna assembly 10 and a capacitive detection component 20. Of course, the earphone 100 may also include other structures well known in the technical field, which are not described herein.

The antenna assembly 10 may be communicatively connected to a terminal device (which may also be referred to as an "electronic device" or a "control terminal"), such as a mobile phone or a computer, to achieve data transmission between the earphone and the terminal device. For example, the earphone 100 may receive audio data transmitted from the terminal device via the antenna assembly 10 and may play the audio data. For example, the earphone 100 may receive program data transmitted from the terminal device via the antenna assembly 10 and use the program data for program upgrade. For example, the earphone 100 may transmit its own working status, such as battery information, user wearing information, and/or fault information, to a terminal device.

In some embodiments, the antenna assembly 10 may be communicatively connected to the terminal device based on a wireless communication connection manner such as Bluetooth or Wireless Fidelity (Wi-Fi).

The capacitive detection component 20 may allow a user to perform human-computer interaction with the earphone 100. In some embodiments, the capacitive detection component 20 may be configured to generate an electrical signal based on a touch action of the user on the earphone 100. That is to say, when the capacitive detection component 20 is triggered, the earphone 100 may generate a control instruction, thereby allowing the earphone 100 to implement a preset function. In some embodiments, the touch action may include one or more of a click, a double-click, a long press, a slide, or the like. In some embodiments, the control instruction may be used to implement one or more functions such as volume increase/decrease, play/pause, next track, power on/off, or the like. In some embodiments, when the user operates the earphone 100, for example, when the user presses a region of the earphone 100 where the capacitive detection component 20 is located, the user may contact the capacitive detection component 20 to generate an electrical signal, thereby generating a control instruction corresponding to the electrical signal.

In some embodiments, the capacitive detection component 20 may be configured to detect whether the user is wearing the earphone 100 and generate an electrical signal, thereby allowing the earphone 100 to implement a preset function, such as a wearing detection function. In some embodiments, when the user wears the earphone 100, the capacitive detection component 20 is triggered by an ear or the head of the user to generate an electrical signal, thereby generating a control instruction corresponding to the electrical signal.

It should be noted that the wearing detection performed by the earphone 100 may bring the following benefits: 1) Extending the battery life of the earphone 100. For example, the earphone 100 is in a power-off or standby state when a detection result indicates that the earphone 100 is not worn by the user. 2) Improving the privacy of the earphone 100. For example, the earphone 100 pauses audio data that was being played previously when the detection result indicates that the earphone 100 is not worn by the user. 3) Avoiding the earphone 100 from establishing a communication connection with the terminal device when it is unnecessary. For example, the earphone 100 does not establish a communication connection with the terminal device when it is placed in a charging case and the charging case is in an open state.

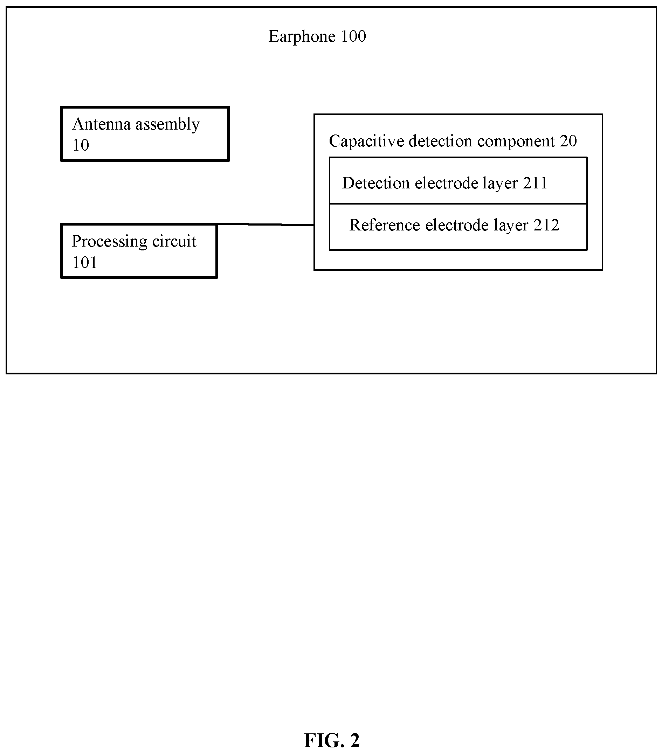

Please refer to FIG. 2. FIG. 2 is a block diagram illustrating the earphone 100 shown in FIG. 1 according to some other embodiments of the present disclosure. The earphone 100 may further include a processing circuit 101. The processing circuit 101 may be electrically connected to the capacitive detection component 20, receive the electrical signal generated by the capacitive detection component 20, and process the electrical signal to implement the preset function of the earphone 100 in the above embodiments.

Please refer to FIG. 1. The capacitive detection component 20 is within a radiation range of the antenna assembly 10. The inventors have found the following through research.

An electromagnetic wave emitted by the antenna assembly 10 may be coupled to the capacitive detection component 20 to a certain extent. The capacitive detection component 20 may contact a human body and/or be arranged close to the human body, thereby causing the electromagnetic energy coupled to the capacitive detection component 20 to be absorbed by the human body, further causing a decrease in the antenna efficiency of the antenna assembly 10. For example, the capacitive detection component 20 for achieving wearing detection is close to the human body, causing the electromagnetic energy to be absorbed by the user's head, ultimately leading to a decrease in the antenna efficiency. As another example, the capacitive detection component 20 for implementing a touch operation is close to the human body, causing the electromagnetic energy to be absorbed by the human body, ultimately leading to a decrease in the antenna efficiency. As a further example, the capacitive detection component 20 for implementing the touch operation is subjected to a touch action of the user, causing the electromagnetic energy to be absorbed by the human body, ultimately leading to a decrease in the antenna efficiency. Of course, the impact of the capacitive detection component 20 on the antenna efficiency of the antenna assembly 10 is not limited to the manners listed here.

The inventors have found through research that the impact of the capacitive detection component 20 on the antenna assembly 10 can be reduced by providing a serpentine trace and/or a ground line. Compared to the impact exerted by a capacitive detection component 20 without a serpentine trace and a ground line on the antenna assembly 10, the impact of the capacitive detection component 20 provided with the serpentine trace and/or the ground line on the antenna assembly 10 is lower. As a result, the antenna efficiency of the antenna assembly 10 is improved due to the provision of the serpentine trace and/or the ground line for the capacitive detection component 20. In some embodiments, the inventors fully utilize the distributed inductance and distributed capacitance of the serpentine trace to create a low-pass high-resistance filter (allowing a low-frequency signal to pass while blocking a high-frequency signal), so that the serpentine trace forms a filter network to suppress the high-frequency signal coupled from the antenna assembly 10 to the capacitive detection component 20, reduce the transmission of electromagnetic energy between the antenna assembly 10 and the capacitive detection component 20, thereby achieving a shielding and isolation effect and improving the antenna efficiency of the antenna assembly 10. In some embodiments, the inventors improve the capacitive detection component 20 by using a ground line, so that the electromagnetic energy coupled to the capacitive detection component 20 is coupled to the ground line, the signal coupled from the antenna assembly 10 to the capacitive detection component 20 is suppressed, and the transmission of electromagnetic energy between the antenna assembly 10 and the capacitive detection component 20 is reduced, thereby achieving the shielding and isolation effect and improving the antenna efficiency.

The capacitive detection component 20 provided with the serpentine trace and/or the ground line is described below.

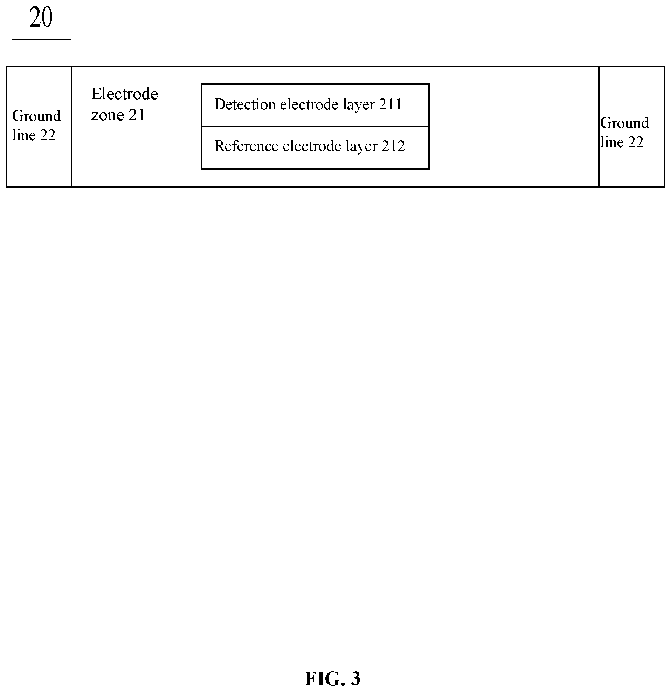

Please refer to FIG. 3. FIG.3 is a block diagram illustrating a capacitive detection component of the earphone shown in FIG. 1 according to some embodiments of the present disclosure. The capacitive detection component 20 may be provided with an electrode zone 21 and a ground line 22. The electrode zone 21 may be configured to generate the electrical signal in the above embodiments. The ground line 22 may be electrically connected to a ground in the earphone 100. The ground line 22 is arranged around the electrode zone 21 and is spaced apart from the electrode zone 21. By arranging the ground line around the electrode zone 21, the signal coupled from the antenna assembly 10 to the capacitive detection component 20 is suppressed, and the transmission of electromagnetic energy between the antenna assembly 10 and the capacitive detection component 20 is reduced, thereby achieving the shielding and isolation effect and improving the antenna efficiency of the antenna assembly 10.

In some embodiments, the electrode zone 21 may include a detection electrode layer 211 and a reference electrode layer 212 stacked together. Both the detection electrode layer 211 and the reference electrode layer 212 may be electrically connected to the processing circuit 101. The detection electrode layer 211 is configured to generate the electrical signal in the above embodiments. The reference electrode layer 212 is configured to generate a noise cancellation signal. The noise cancellation signal and the electrical signal are transmitted to the processing circuit 101. The processing circuit 101 utilizes the noise cancellation signal to remove noise from the electrical signal, thereby reducing the noise floor of the electrical signal and improving a signal-to-noise ratio. In some embodiments, the reference electrode layer 212 is configured to suppress temperature drift. In some embodiments, in the earphone 100, during a touch operation or wearing detection, the detection electrode layer 211 is closer to a human body than the reference electrode layer 212.

In some embodiments, the reference electrode layer 212 is omitted, and the electrical signal is generated by the detection electrode layer 211.

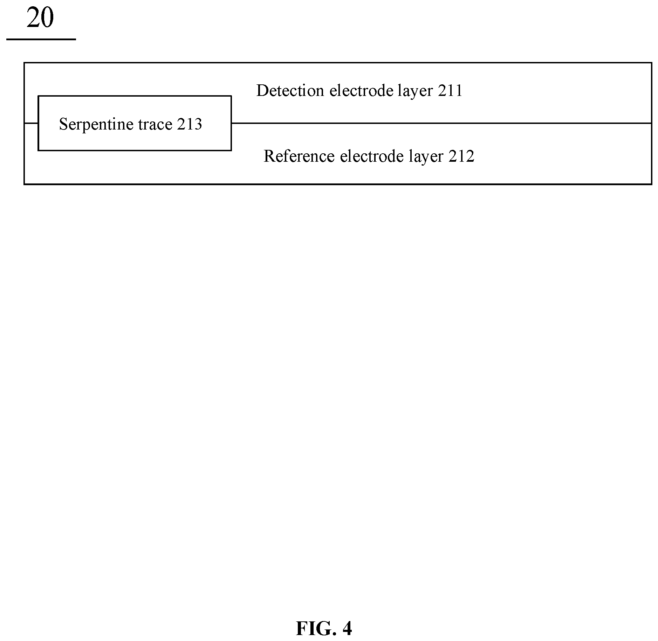

Please refer to FIG. 4. FIG. 4 is a block diagram illustrating the capacitive detection component 20 of the earphone shown in FIG. 1 according to some embodiments of the present disclosure. The capacitive detection component 20 includes a detection electrode layer 211 and a reference electrode layer 212 stacked together. The detection electrode layer 211 and/or the reference electrode layer 212 includes a serpentine trace 213. At least a portion of the serpentine trace 213 is disposed in an overlapping region of the detection electrode layer 211 and the reference electrode layer 212 in a stacking direction. The distributed inductance and distributed capacitance of the serpentine trace 213 are equivalent to a low-pass high-impedance network, which suppresses a high-frequency signal coupled from the antenna assembly 10 to the capacitive detection component 20, thereby reducing the transmission of electromagnetic energy between the antenna assembly 10 and the capacitive detection component 20, and achieving the shielding and isolation effect and improving the antenna efficiency of the antenna assembly 10. In some embodiments, the serpentine trace 213 is entirely disposed in the overlapping region of the detection electrode layer 211 and the reference electrode layer 212 in the stacking direction.

In the present disclosure, the overlapping region is provided in the detection electrode layer 211 and the reference electrode layer 212. On a reference plane perpendicular to the stacking direction, an orthogonal projection of a portion of the detection electrode layer 211 that overlaps with the reference electrode layer 212 coincides with an orthogonal projection of a portion of the reference electrode layer 212 that overlaps with the detection electrode layer 211.

FIG. 4 does not show the ground line 22 described in FIG. 3 and the above embodiments, and only shows the structure of the electrode zone 21. That is to say, the capacitive detection component 20 may not include the ground line 22 when the serpentine trace 213 is provided. Of course, the capacitive detection component 20 in FIG. 4 may also include the ground line 22 as described in FIG. 3 and the above embodiments, which is not repeated herein.

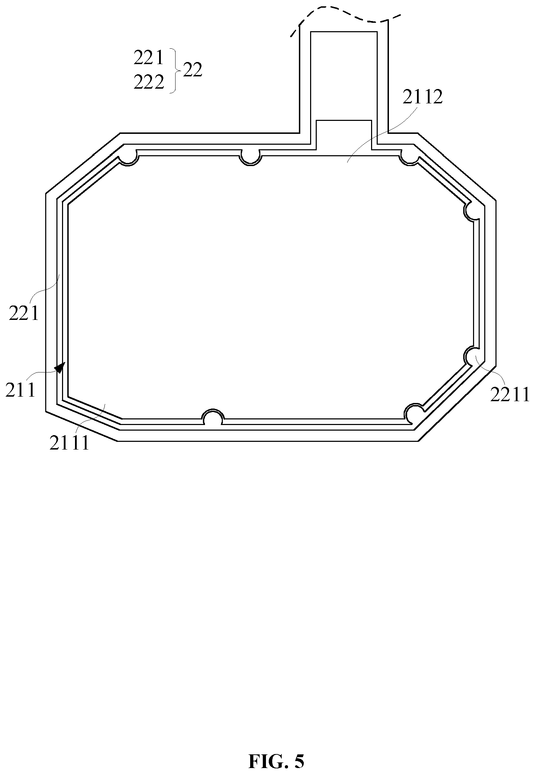

Please refer to FIG. 5. FIG. 5 is a schematic diagram illustrating a partial structure of the capacitive detection component 20 shown in FIG. 3 according to some embodiments of the present disclosure. The ground line 22 includes a first ground line 221. The first ground line 221 is disposed in a same layer as the detection electrode layer 211 and arranged around the detection electrode layer 211. The first ground line 221 provides a shielding and isolation effect for the detection electrode layer 211 and the reference electrode layer 212, thereby improving the antenna efficiency of the antenna assembly 10.

In some embodiments, to improve the shielding and isolation effect of the ground line 22 (e.g., the first ground line 221) on the detection electrode layer 211 and the reference electrode layer 212, a spacing between the detection electrode layer 211 and the first ground line 221 is greater than or equal to 0.2 mm.

In some embodiments, a line width of the ground line 22 (e.g., the first ground line 221) may not be too narrow; otherwise, it is difficult to achieve the shielding and isolation effect. However, the line width may not be too wide; otherwise, more current may be distributed on the ground line 22 (e.g., the first ground line 221). When the ground line 22(e.g., the first ground line 221) is relatively close to the human body, the current is more easily absorbed by the human body, which also reduces the antenna efficiency of the antenna assembly 10. Therefore, to ensure the shielding and isolation effect of the ground line 22 (e.g., the first ground line 221), the line width of the first ground line 221 is between 0.1 mm and 0.3 mm.

In some embodiments, as a main structure of the capacitive detection component 20, the detection electrode layer 211 has relatively high requirements for the shielding and isolation effect. Therefore, to improve the shielding and isolation effect of the ground line 22 (e.g., the first ground line 221) on the detection electrode layer 211 and the reference electrode layer 212, the first ground line 221 is disposed around the detection electrode layer 211 in a closed-loop manner.

Please refer to FIG. 5, a first electrode 2111 in the detection electrode layer 211 is a sheet-like structure. By laying out the entire sheet-like structure, an area of the first electrode 2111 is increased, thereby improving the detection sensitivity of the capacitive detection component 20 (e.g., the detection electrode layer 211).

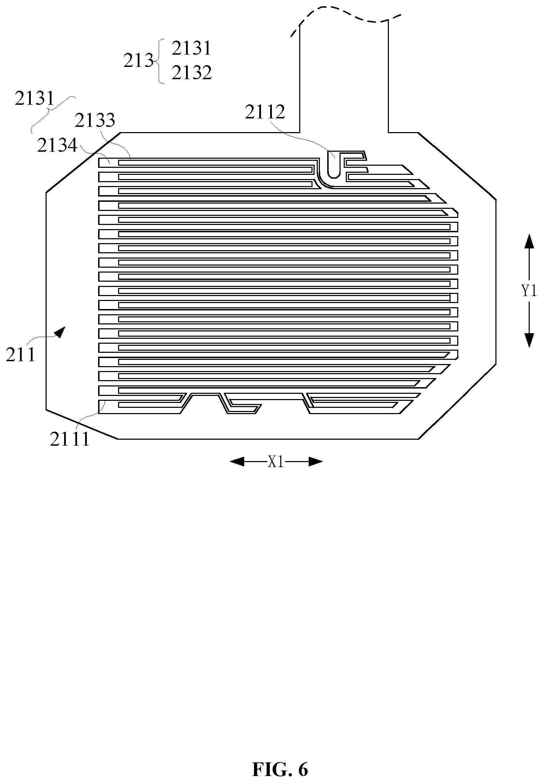

Please refer to FIG. 6. FIG. 6 is a schematic diagram illustrating a partial structure of the capacitive detection component 20 shown in FIG. 3 according to some embodiments of the present disclosure. The serpentine trace 213 includes a first serpentine trace 2131. The first serpentine trace 2131 is disposed in the detection electrode layer 211. That is to say, the first electrode 2111 may be the first serpentine trace 2131.

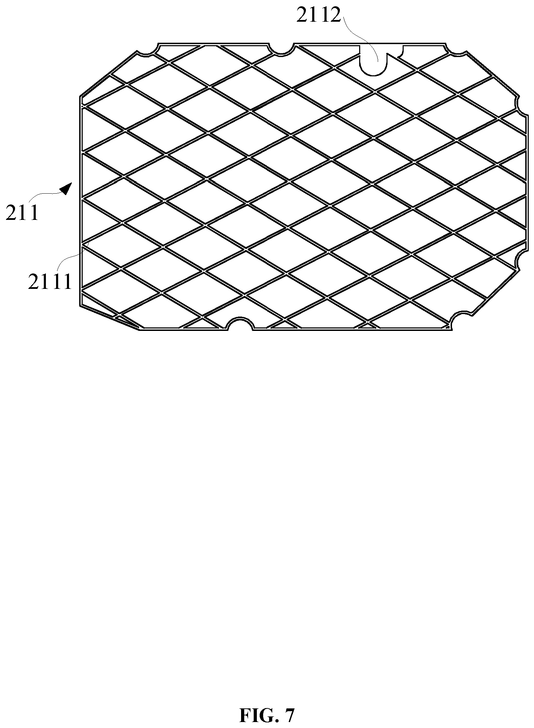

Please refer to FIG. 7. FIG. 7 is a schematic diagram illustrating a partial structure of the capacitive detection component 20 shown in FIG. 3 according to some embodiments of the present disclosure. The detection electrode layer 211 includes a grid line. That is to say, the first electrode 2111 may be the grid line.

It may be understood, a partial structure of the first electrode 2111 in the detection electrode layer 211 may be a combination of the structures in the above embodiments. For example, the partial structure of the first electrode 2111 is the sheet-like structure. As another example, the partial structure of the first electrode 2111 is the grid line. As yet another example, the partial structure of the first electrode 2111 is the first serpentine trace 2131. As a further example, the partial structure of the first electrode 2111 is at least one of the sheet-like structure, the grid line, or the first serpentine trace 2131.

Of course, the specific structure of the first electrode 2111 is not limited to the embodiments listed herein, and may also be a structure well known in the art, which is not repeated herein.

Please refer to FIG. 6. The first serpentine trace 2131 includes a plurality of main extension portions (e.g., a plurality of first main extension portions 2133) and a plurality of connection portions (e.g., a plurality of first connection portions 2134). The plurality of first main extension portions 2133 are arranged side by side at intervals along a first direction Y1 and extend along a direction intersecting with the first direction Y1. The plurality of first connection portions 2134 sequentially connect the plurality of first main extension portions 2133.

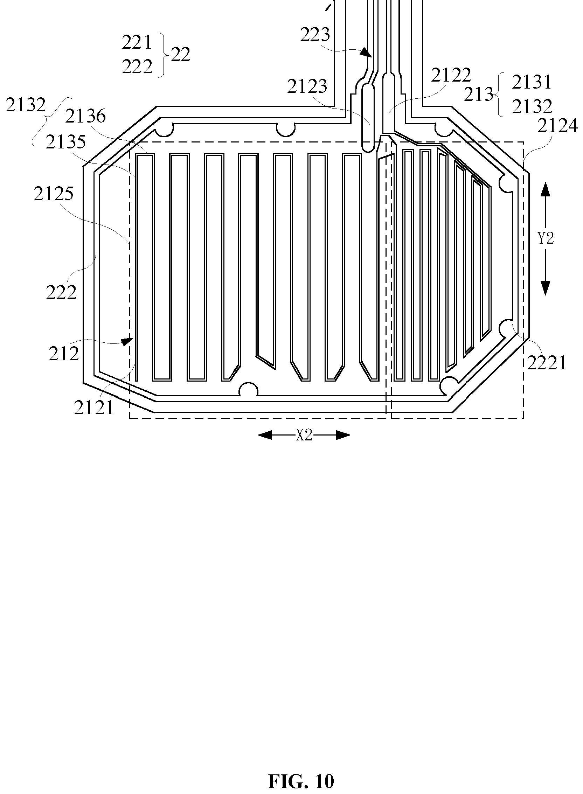

In some embodiments, the direction intersecting with the first direction Y1 may be the same as or different from a second direction X2 (see FIG. 10). In some embodiments, the direction intersecting with the first direction Y1 is denoted as a third direction X1. The third direction X1 may be the same as or different from the second direction X2. In some embodiments, the first direction Y1 is perpendicular to the second direction X2 and/or the third direction X1.

In some embodiments, a line width of the serpentine trace 213, e.g., the first serpentine trace 2131, should not be too wide; otherwise, it is difficult to achieve a high impedance when the antenna assembly 10 establishes a Bluetooth communication connection with a terminal device. Therefore, to ensure an inductance effect of the serpentine trace 213 (e.g., the first serpentine trace 2131), the line width of the first main extension portion 2133 is less than or equal to 0.3 mm. In some embodiments, the line width of the first connection portion 2134 is less than or equal to 0.3 mm.

In some embodiments, in the serpentine trace 213 (e.g., the first serpentine trace 2131), to construct a relatively high inter-line parasitic capacitance, a spacing between each pair of adjacent first main extension portions 2133 also needs to be as narrow as possible. The spacing between each pair of adjacent first main extension portions 2133 is less than or equal to 0.5 mm.

In some embodiments, the detection electrode layer 211 has a terminal 2112. The terminal 2112 is electrically connected to the first electrode 2111 and the processing circuit 101, thereby achieving an electrical connection between the first electrode 2111 and the processing circuit 101.

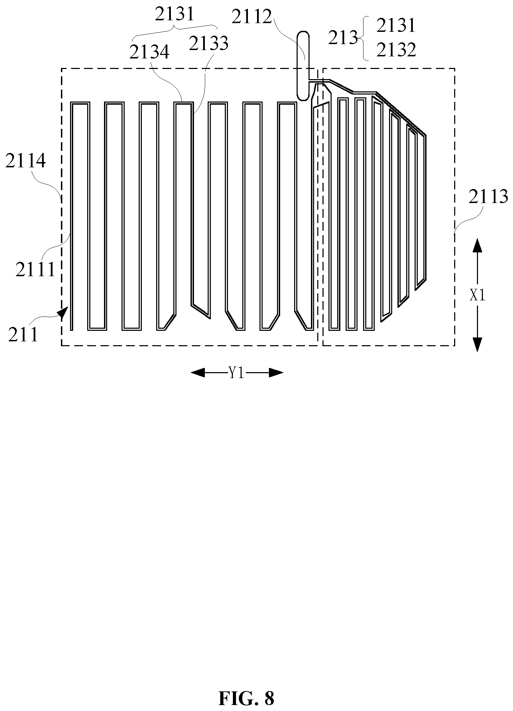

Please refer to FIG. 8. FIG.8 is a schematic diagram illustrating a partial structure of the capacitive detection component 20 shown in FIG. 3 according to some embodiments of the present disclosure. The detection electrode layer 211 includes a dense region 2113 and a sparse region 2114. The plurality of first main extension portions 2133 are provided in the dense region 2113 and the sparse region 2114. To balance the two factors of high impedance and small parasitic capacitance in the serpentine trace 213 (e.g., the first serpentine trace 2131), a portion of the serpentine trace 213 (e.g., the first serpentine trace 2131) is designed to be denser. This causes a spacing between each pair of adjacent first main extension portions 2133 in the dense region 2113 to be less than a spacing between each pair of adjacent first main extension portions 2133 in the sparse region 2114. Thus, the first serpentine trace 2131 is densely arranged in the dense region 2113 and sparsely arranged in the sparse region 2114.

In some embodiments, the terminal 2112 is connected to the first main extension portions 2133 in the sparse region 2114 via the first main extension portions 2133 in the dense region 2113.

In some embodiments, if the parasitic capacitance in the serpentine trace 213 (e.g., the first serpentine trace 2131), and/or the parasitic capacitance between the reference electrode layer 212 and the detection electrode layer 211 is too high, it may be more difficult for the processing circuit 101 to calibrate the parasitic capacitance, which may even cause a failure of the wearing detection function of the earphone 100. An area of the dense region 2113 is less than an area of the sparse region 2114, which can reduce the parasitic capacitance in the serpentine trace 213 (e.g., the first serpentine trace 2131), and/or the parasitic capacitance between the reference electrode layer 212 and the detection electrode layer 211, thereby minimizing the difficulty for the processing circuit 101 to calibrate the parasitic capacitance and ensuring the wearing detection function of the earphone 100.

In some embodiments, the area of the dense region 2113 may be greater than or equal to the area of the sparse region 2114.

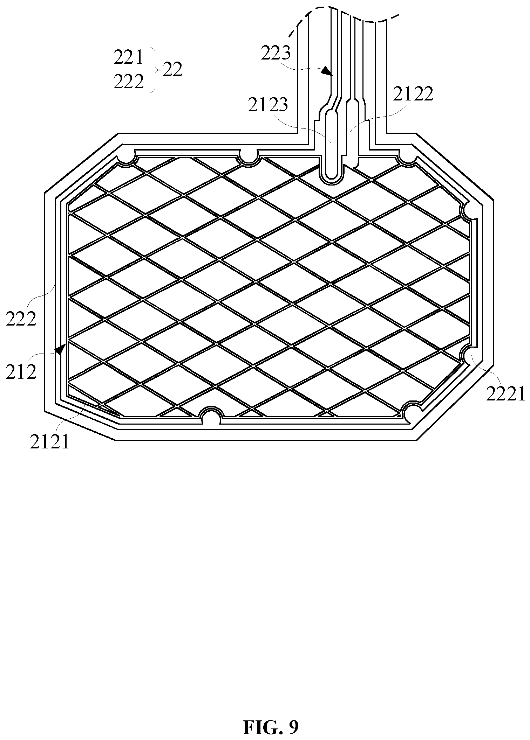

Please refer to FIG. 9. FIG. 9 is a schematic diagram illustrating a partial structure of the capacitive detection component 20 shown in FIG. 3 according to some embodiments of the present disclosure. The ground line 22 may include a second ground line 222. The second ground line 222 may be disposed in the same layer as the reference electrode layer 212 and arranged around the reference electrode layer 212. The second ground line 222 may provide a shielding and isolation effect for the detection electrode layer 211 and the reference electrode layer 212, thus improving the antenna efficiency of the antenna assembly 10. In some embodiments, both the first ground line 221 and the second ground line 222 may be omitted. In some embodiments, one of the first ground line 221 and the second ground line 222 may be omitted. The other one of the first ground line 221 and the second ground line 222 may be arranged according to the manner in the above embodiments. Certainly, the other one of the first ground line 221 and the second ground line 222 may also be arranged between the detection electrode layer 211 and the reference electrode layer 212, or on a side of the detection electrode layer 211 away from the reference electrode layer 212, or on a side of the reference electrode layer 212 away from the detection electrode layer 211. In some embodiments, the first ground line 221 and the second ground line 222 may be an integral structure. For example, a same conductive wire is arranged around both the detection electrode layer 211 and the reference electrode layer 212.

In some embodiments, to improve the shielding and isolation effect of the ground line 22 (e.g., the second ground line 222) on the detection electrode layer 211 and the reference electrode layer 212, a spacing between the reference electrode layer 212 and the second ground line 222 is greater than or equal to 0.2 mm.

In some embodiments, a line width of the ground line 22 (e.g., the second ground line 222) should not be too narrow; otherwise, it is difficult to achieve the shielding and isolation effect. However, the line width of the ground line 22 (e.g., the second ground line 222) should not be too wide either; otherwise, more current may be distributed on the ground line 22 (e.g., the second ground line 222). When the ground line 22, e.g., the second ground line 222, is relatively close to a human body, the current is more easily absorbed by the human body, which also reduces the antenna efficiency of the antenna assembly 10. Therefore, to ensure the shielding and isolation effect of the ground line 22 (e.g., the second ground line 222), the line width of the second ground line 222 may be between 0.1 mm and 0.3 mm.

In some embodiments, the second ground line 222 may be electrically connected to the first ground line 221 to simplify the circuit in the earphone 100. In some embodiments, to improve the electrical connection strength between the second ground line 222 and the first ground line 221, achieve uniform current distribution, and ensure a grounding effect, the second ground line 222 and the first ground line 221 may be electrically connected through an interlayer connection via a plurality of connection points (e.g., the first connection point 2211 (see FIG. 5) and the second connection point 2221 (see FIG. 9)) arranged at intervals along a circumferential direction. Referring to FIG. 5, in some embodiments, the first connection points 2211 may be arranged at intervals along a circumferential direction of the first ground line 221. Referring to FIG. 9, the second connection points 2221 may be arranged at intervals along a circumferential direction of the second ground line 222. Correspondingly, the first ground line 221 and the second ground line 222 are electrically connected through an interlayer connection.

In some embodiments, in the capacitive detection component 20, compared to the detection electrode layer 211, the reference electrode layer 212 is slightly farther from the human body, resulting in a relatively weak ability to couple the energy of a high-frequency signal from the antenna assembly 10. Compared to the detection electrode layer 211, the reference electrode layer 212 has lower requirements for the shielding and isolation effect. Therefore, as shown in FIG. 9, the second ground line 222 may not be arranged around the reference electrode layer 212 in a closed-loop manner, thereby forming a notch 223. Certainly, the second ground line 222 may also be arranged around the reference electrode layer 212 in a closed-loop manner.

In some embodiments, an effective area of the detection electrode layer 211 is greater than an effective area of the reference electrode layer 212. Thus, the ability of the reference electrode layer 212 to couple energy of the high-frequency signal from the antenna assembly 10 is weaker, resulting in lower requirements for the shielding and isolation effect compared to the detection electrode layer 211. Further, please refer to FIG. 9, the notch 223 may be formed on the second ground line 222.

In some embodiments, the capacitive detection component 20 may further include a first terminal 2122 and a second terminal 2123 disposed in the same layer as the reference electrode layer 212. Since the reference electrode layer 212 has lower requirements for the shielding and isolation effect, compared to the detection electrode layer 211, both the first terminal 2122 and the second terminal 2123 may be disposed on the reference electrode layer 212. This arrangement ensures the completeness of the closed-loop configuration of the first ground line 221 and further enhances its shielding and isolation effect on the detection electrode layer 211. Thus, the reference electrode layer 212 may be electrically connected in the same layer as the first terminal 2122. The detection electrode layer 211 may be electrically connected to the second terminal 2123 through an interlayer connection. The first ground line 221 is electrically connected to the second ground line 222 through an interlayer connection and is grounded via the second ground line 222. The notch 223 allows the first terminal 2122 and the second terminal 2123 to be led out. In some embodiments, the terminal 2112 of the detection electrode layer 211 may be electrically connected to the second terminal 2123 through an interlayer connection. In some embodiments, the first ground line 221 and the second ground line 222 may be electrically connected through an interlayer connection via the first connection point 2211 and the second connection point 2221. In some embodiments, after being led out through the notch 223, the first terminal 2122 and the second terminal 2123 may be electrically connected to the processing circuit 101.

Please refer to FIG. 9. A second electrode 2121 in the reference electrode layer 212 may be a grid line to reduce the effective area of the reference electrode layer 212.

Please refer to FIG. 10. FIG. 10 is a schematic diagram illustrating a partial structure of the capacitive detection component 20 shown in FIG. 3 according to some embodiments of the present disclosure. The serpentine trace 213 may include a second serpentine trace 2132. The second serpentine trace 2132 is arranged in the reference electrode layer 212. That is to say, the second electrode 2121 may be the second serpentine trace 2132.

In some embodiments, the second electrode 2121 may also be a sheet-like structure.

It may be understood that a partial structure of the second electrode 2121 in the reference electrode layer 212 may also be a combination of the structures in the above embodiments. For example, the partial structure of the second electrode 2121 may be the sheet-like structure. As another example, a partial structure of the second electrode 2121 may be the grid line. As yet another example, the partial structure of the second electrode 2121 may be the second serpentine trace 2132. As a further example, at least a portion of the second electrode 2121 may be at least one of the sheet-like structure, the grid line, or the second serpentine trace 2132.

Certainly, the structure of the second electrode 2121 is not limited to the embodiments listed here and may also be a structure well-known in the art, which will not be elaborated.

Please refer to FIG. 10. The second serpentine trace 2132 may include a plurality of main extension portions (e.g., a plurality of second main extension portions 2135) and a plurality of connection portions (e.g., a plurality of second connection portions 2136). The plurality of second main extension portions 2135 may be arranged side by side at intervals along the second direction X2 and extend along a direction intersecting with the second direction X2. The plurality of second connection portions 2136 sequentially connect the plurality of second main extension portions 2135.

In some embodiments, the direction intersecting with the second direction X2 may be the same as or different from the first direction Y1. In some embodiments, the direction intersecting with the second direction X2 may be denoted as a fourth direction Y2. Thus, the fourth direction Y2 may be the same as or different from the first direction Y1. In some embodiments, the second direction X2 may be perpendicular to the fourth direction Y2 and/or the first direction Y1.

In some embodiments, the second serpentine trace 2132 cooperates with the first serpentine trace 2131. When the second direction X2 intersects with the first direction Y1 and the fourth direction Y2 intersects with the third direction X1, the second main extension portion 2135 and the first main extension portion 2133 can be arranged in an interleaved manner. This arrangement reduces an overlapping area between the second main extension portion 2135 and the first main extension portion 2133 in the stacking direction, thereby reducing the parasitic capacitance between the reference electrode layer 212 and the detection electrode layer 211. In some embodiments, the second direction X2 is perpendicular to the first direction Y1, and the fourth direction Y2 is perpendicular to the third direction X1, thereby further reducing the overlapping area between the second main extension portion 2135 and the first main extension portion 2133 in the stacking direction. Thus, the first direction Y1 is the same as the fourth direction Y2, and the third direction X1 is the same as the second direction X2.

In some embodiments, a line width of the serpentine trace 213(e.g., the second serpentine trace 2132) should not be too wide; otherwise, it is difficult to achieve high impedance when the antenna assembly 10 establishes a Bluetooth communication connection with a terminal device. To ensure the inductance effect of the serpentine trace 213(e.g., the second serpentine trace 2132), a line width of the second main extension portion 2135 may be less than or equal to 0.3 mm. In some embodiments, a line width of the second connection portion 2136 may be less than or equal to 0.3 mm.

In some embodiments, in the serpentine trace 213 (e.g., the second serpentine trace 2132), to construct a high inter-line parasitic capacitance, a spacing between each pair of adjacent second main extension portions 2135 should be as narrow as possible. The spacing between each pair of adjacent second main extension portions 2135 may be less than or equal to 0.5 mm.

In some embodiments, the reference electrode layer 212 has a terminal, e.g., the first terminal 2122. The terminal (e.g., the first terminal 2122) may be electrically connected to the second electrode 2121 and the processing circuit 101 to achieve the electrical connection between the second electrode 2121 and the processing circuit 101.

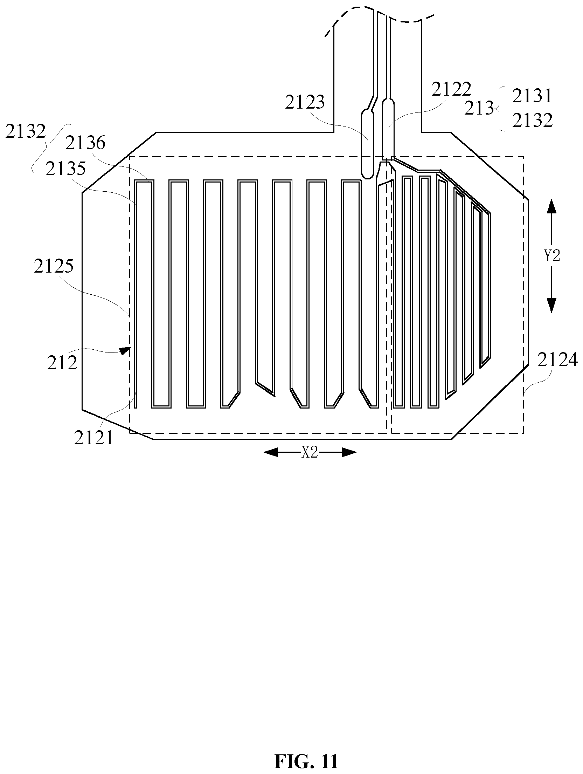

Please refer to FIG. 10 and FIG. 11. FIG. 11 is a schematic diagram illustrating a partial structure of the capacitive detection component 20 shown in FIG. 3 according to some embodiments of the present disclosure. The reference electrode layer 212 may include a first region 2124 and a second region 2125. The plurality of second main extension portions 2135 may be disposed in the first region 2124 and the second region 2125. To balance two factors, a high impedance and a small parasitic capacitance, in the serpentine trace 213 (e.g., the second serpentine trace 2132), a portion of the serpentine trace 213 (e.g., the second serpentine trace 2132) needs to be designed more densely. A spacing between each pair of adjacent second main extension portions 2135 in the first region 2124 is less than a spacing between each pair of adjacent second main extension portions 2135 in the second region 2125 such that the second serpentine trace 2132 is densely arranged in the first region 2124 and sparsely arranged in the second region 2125. The first region 2124 may be referred to as a "dense region." The second region 2125 may be referred to as a "sparse region."

In some embodiments, the terminal (e.g., the first terminal 2122) is connected to the plurality of second main extension portions 2135 in the second region 2125 via the plurality of second main extension portions 2135 in the first region 2124.

In some embodiments, if the parasitic capacitance in the serpentine trace 213(e.g., the second serpentine trace 2132) and/or the parasitic capacitance between the reference electrode layer 212 and the detection electrode layer 211 is too high, it may be more difficult for the processing circuit 101 to calibrate the parasitic capacitance or even cause failure of the wearing detection function of the earphone 100. The area of the first region 2124 is less than the area of the second region 2125 to reduce the parasitic capacitance in the serpentine trace 213 (e.g., the second serpentine trace 2132) and/or the parasitic capacitance between the reference electrode layer 212 and the detection electrode layer 211, thereby making it easier for the processing circuit 101 to calibrate the parasitic capacitance as much as possible, and ensuring the wearing detection function of the earphone 100.

In some embodiments, the area of the first region 2124 may be greater than or equal to the area of the second region 2125.

An earphone 100 is described next. The earphone 100 may be configured using the method in the foregoing embodiments. The earphone 100 is described below by taking an ear-clip earphone as an example.

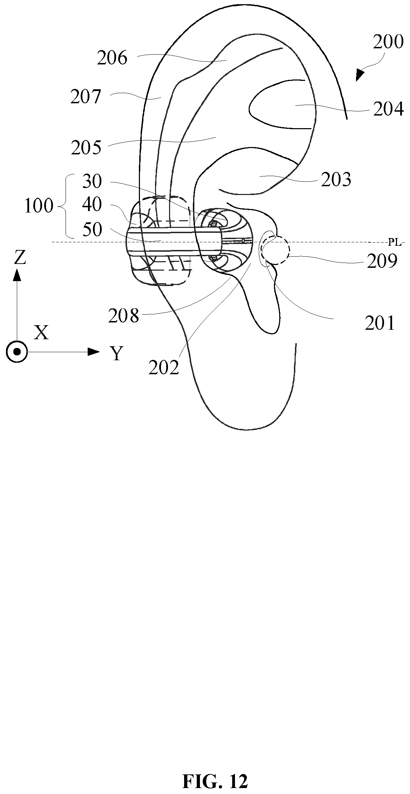

Please refer to FIG. 12. FIG. 12 is a schematic diagram illustrating an earphone worn by a user according to some embodiments of the present disclosure. An ear 200 of the user may include physiological parts such as an external ear canal 201, a concha cavity 202, a cymba conchae 203, a triangular fossa 204, an antihelix 205, a scapha 206, a helix 207, , an antitragus 208, etc. The external ear canal 201 has a certain depth and extends to a tympanic membrane of the ear. For ease of description, unless otherwise specified, the external ear canal 201 refers to an entrance (i.e., an ear hole) of the ear facing away from the tympanic membrane. Physiological parts such as the concha cavity 202, the cymba conchae 203, the triangular fossa 204, etc. have a certain volume and depth, and the concha cavity 202 is directly connected to the external ear canal 201. Therefore, the ear hole may be regarded as being located at a bottom portion of the concha cavity 202.

The external ear canal of the ear 200 is surrounded by a tragus 209. Unlike parts such as the concha cavity 202, the cymba conchae 203, the triangular fossa 204, etc., which have certain depth and volume in three-dimensional space (i.e., these parts are recessed toward a rear side of the ear along a direction closer to the user's head), the tragus 209 protrudes toward a front side of the ear along a direction away from the user's head. The "front side of the ear" is a concept relative to the "rear side of the ear". The front side of the ear refers to a side of the ear away from the head, as shown in FIG. 1. The rear side of the ear refers to a side of the ear facing the head. Both terms are defined relative the ear of the user.

Different users may have individual differences, resulting in dimensional differences such as different shapes and sizes of the ear. To facilitate description and minimize (or even eliminate) the impact of such individual differences, and for clarity of understanding, unless otherwise specified, the present disclosure mainly uses an ear model with a "standard" shape and size as a reference to further describe a wearing manner of the earphone 100 on the ear model in different embodiments. By way of example, a simulator (e.g., GRAS 45BC KEMAR) containing a head and its (left and right) ears, manufactured based on standards such as ANSI: S3.36, S3.25, and IEC: 60318-7, may be used as a reference for wearing the earphone 100, thereby presenting a scenario of how most users normally wear the earphone 100.

Merely by way of example, the ear of the simulator used as a reference may have the following relevant features: a dimension of a projection of an auricle on a sagittal plane in a direction of a vertical axis may be in a range of 49.5 mm to 74.3 mm, and a dimension of a projection of the auricle on the sagittal plane in a direction of a sagittal axis may be in a range of 36.6 mm to 55 mm.

In the present disclosure, descriptions such as "in a state where a user wears the earphone," "in a wearing state," and "under worn conditions" regarding the wearing of the earphone 100 refer to the earphone 100 being worn on the ear of the aforementioned simulator. Naturally, individual variations among users may result in differences in the structure, shape, size, thickness, or other characteristics of one or more parts of the ear 200. To accommodate diverse user needs, the earphone 100 may be designed with variations. These variations may manifest as feature parameters of one or more components (e.g., a sound-producing portion 30, an abutting portion 40, an ear hook portion 50, etc., described below) of the earphone 100 having values within different ranges, thereby adapting to various ear shapes.

It should be noted that in fields such as medicine and anatomy, three basic planes of the human body, including a sagittal plane, a coronal plane, and a horizontal plane, and three basic axes, including a sagittal axis, a coronal axis, and a vertical axis, may be defined. The sagittal plane refers to a plane perpendicular to the ground and runs along a front-to-rear direction of the human body, which divides the body into a left part and a right part. The coronal plane refers to a plane perpendicular to the ground and runs along a left-to-right direction of the body, which divides the body into an anterior part and a posterior part. The horizontal plane refers to a plane parallel to the ground and runs along a top-to-bottom direction of the body, which divides the body into an upper part and a lower part. Correspondingly, the sagittal axis is an axis along the front-to-rear direction of the body and perpendicular to the coronal plane, the coronal axis is an axis along the left-to-right direction of the body and perpendicular to the sagittal plane, and the vertical axis is an axis along the top-to-bottom direction of the body and perpendicular to the horizontal plane.

Observing the ear of the simulator along a direction of the coronal axis of the human body, a schematic diagram of an anterior contour of the ear shown in FIG. 12 may be obtained. Furthermore, referring to FIG. 12, an X direction, a Y direction, and a Z direction may be simply regarded as the coronal axis of the human body, the sagittal axis of the human body, and the vertical axis of the human body, respectively. An X-Y plane, an X-Z plane, and a Y-Z plane may be simply regarded as the horizontal plane of the human body, the coronal plane of the human body, and the sagittal plane of the human body, respectively.

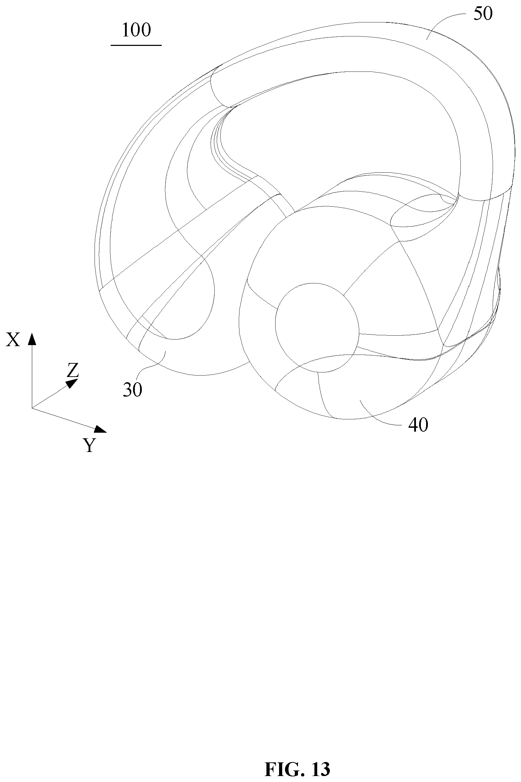

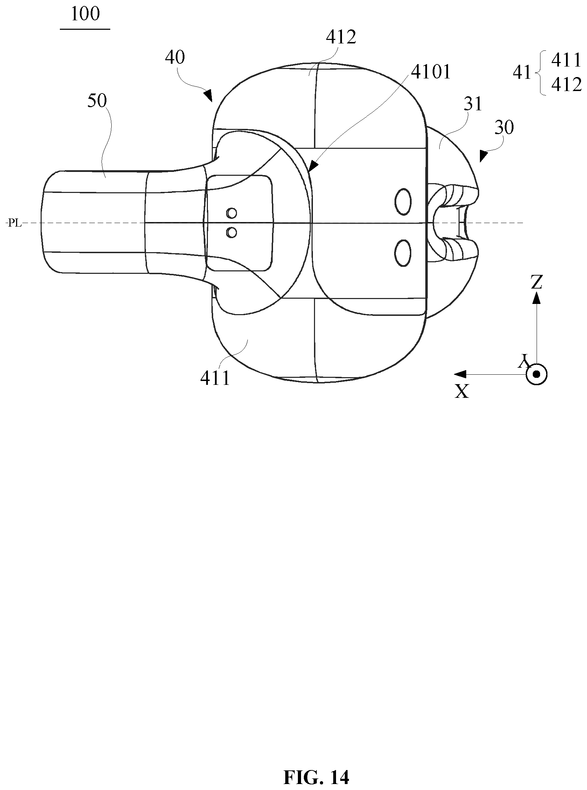

Please refer to FIGs. 12 to 14. FIG. 13 is a schematic diagram illustrating the earphone shown in FIG. 12 from one perspective. FIG. 14 is a schematic diagram illustrating the earphone shown in FIG. 12 from another perspective. The earphone 100 may include a sound-producing portion 30 inserted into a concha cavity 202 of a wearer, an abutting portion 40 for abutting behind an ear of the wearer, and an ear hook portion 50 connected to the sound-producing portion 30 and the abutting portion 40. The sound-producing portion 30 is a sound playback device. The sound-producing portion 30 may be configured to convert an electrical signal into a sound signal and play the sound signal to the wearer. The sound-producing portion 30 is located in the concha cavity 202 in a wearing state. The sound signal may be a bone-conducted sound signal transmitted through bone or an air-conducted sound signal transmitted through air. The abutting portion 40 and the sound-producing portion 30 form a clamping state. The abutting portion 40 abuts against an outer side wall of the concha cavity 202. The sound-producing portion 30 abuts against an inner side wall of the concha cavity 202, so as to clamp and wear the earphone 100 on the ear 200 of a user. The ear hook portion 50 is a component that provides a clamping force for the sound-producing portion 30 and the abutting portion 40. Two ends of the ear hook portion 50 are connected to the sound-producing portion 30 and the abutting portion 40, respectively. In the wearing state, the ear hook portion 50 bypasses the helix 207 so that the sound-producing portion 30 and the abutting portion 40 are located on two sides of the ear along the coronal axis of the human body. The sound-producing portion 30 extends into the concha cavity 202 to transmit sound to the ear canal. In some embodiments, the ear hook portion 50 may have a symmetry plane PL along a length direction of the ear hook portion 50.

The abutting portion 40 may be configured to mount functional components such as a battery, the antenna assembly 10, and/or the capacitive detection component 20. Certainly, the functional components such as the battery, the antenna assembly 10, and/or the capacitive detection component 20 may also be mounted on other structures of the earphone 100, e.g., the sound-producing portion 30 and/or the abutting portion 40. In some embodiments, the antenna assembly 10 may be mounted on the sound-producing portion 30 and/or the abutting portion 40. In some embodiments, the capacitive detection component 20 may be mounted on the sound-producing portion 30 and/or the abutting portion 40.

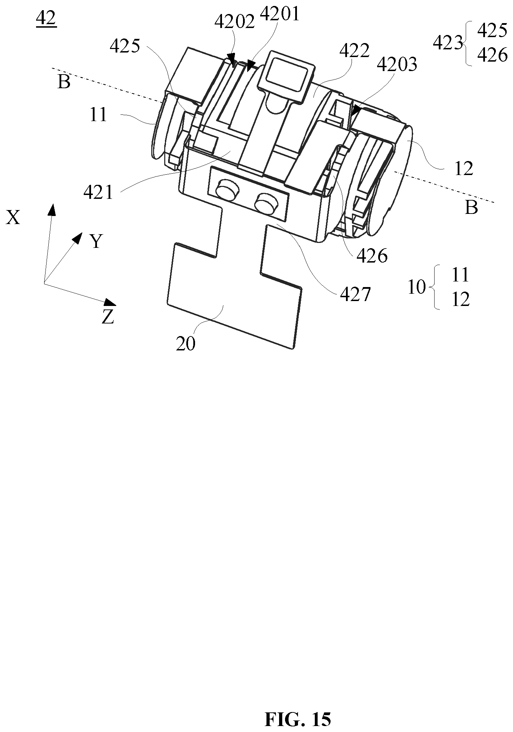

Please refer to FIG. 14. The abutting portion 40 may include a first housing assembly 41 and an assembly 42 (see FIG. 15. FIG. 15 is a schematic diagram illustrating a partial structure of an abutting portion 40 shown in FIG. 14 according to some embodiments of the present disclosure). The first housing assembly 41 may be connected to the ear hook portion 50. The assembly 42 may be mounted in the first housing assembly 41. The assembly 42 may be an aggregate of functional components of the earphone 100 that need to be mounted in the first housing assembly 41. Functional components that need to be arranged in the first housing assembly 41 are integrated and assembled into the assembly 42, thereby effectively improving assembly efficiency and convenience of the earphone 100.

Referring to FIG. 14, the first housing assembly 41 may include a first housing 411 and a second housing 412 connected together. The first housing 411 and the second housing 412 may be connected by welding, adhesion, snap-fit, screw connection, or other connection manners known in the art. The first housing 411 and the second housing 412 form an accommodation cavity for accommodating the assembly 42. In some embodiments, the first housing 411 forms an accommodation cavity with an opening 4101. The second housing 412 is connected to the first housing 411 to cover the opening 4101, thereby sealing the accommodation cavity. This arrangement provides an effective sealed environment for the assembly 42 provided in the accommodation cavity. In some embodiments, the assembly 42 may be placed into the accommodation cavity through the opening 4101. In some embodiments, the assembly 42 may be embedded in the accommodation cavity through the opening 4101. In some embodiments, the first housing 411 may be connected to the ear hook portion 50.

Referring to FIG. 15, the assembly 42 may include the antenna assembly 10, the capacitive detection component 20, a bracket 421, a battery 422, and a circuit board assembly 423. The antenna assembly 10, the capacitive detection component 20, the battery 422, and the circuit board assembly 423 are arranged on the bracket 421 and remain relatively fixed to the bracket 421 to form the assembly 42. The bracket 421 may provide support for the antenna assembly 10, the capacitive detection component 20, the circuit board assembly 423, and the battery 422. During an assembly process, the antenna assembly 10, the capacitive detection component 20, the battery 422, and the circuit board assembly 423 may be spatially arranged on the bracket 421, and then further arranged in the accommodation cavity via the bracket 421, which can effectively reduce the risk of damage to these components during assembly, thereby significantly improving the production yield of the earphone 100.

The bracket 421 may be formed by connecting a plurality of plate-like members. This can ensure the structural strength of the bracket 421 and effectively reduce the overall mass of the bracket 421, thereby effectively reducing the overall mass of the earphone 100. A battery accommodation region 4201, a first circuit board accommodation region 4202, and a second circuit board accommodation region 4203 may be formed on the bracket 421. The battery accommodation region 4201 is configured to assemble the battery 422. The first circuit board accommodation region 4202 and the second circuit board accommodation region 4203 cooperate to assemble the circuit board assembly 423.

In some embodiments, the battery accommodation region 4201, the first circuit board accommodation region 4202, and the second circuit board accommodation region 4203 may be arranged at intervals from each other. In some embodiments, the first circuit board accommodation region 4202 and the second circuit board accommodation region 4203 are located on opposite sides of the battery accommodation region 4201. In some embodiments, the battery accommodation region 4201, the first circuit board accommodation region 4202, and the second circuit board accommodation region 4203 may be arranged along a B-B direction. In some embodiments, the B-B direction is perpendicular to the symmetry plane PL. Certainly, the B-B direction may not be perpendicular to the symmetry plane PL but merely intersect with the symmetry plane PL.

In some embodiments, the bracket 421 is an integrally formed member. That is to say, the bracket 421 may be manufactured by an integral molding process.

Referring to FIG. 15, the battery 422 may be installed in the battery accommodation region 4201. The battery 422 is arranged in a columnar shape. For example, the battery 422 may be a square or rectangular prism with a square or rectangular base, or a cylinder with a circular base. An axial direction of the battery 422 is defined as an extension direction perpendicular to a base surface of the columnar body. In some embodiments, the battery 422 is arranged as a cylinder. In some embodiments, an angle between the axial direction of the battery 422 and the B-B direction is set to be greater than or equal to 0° and less than or equal to 30°. This arrangement effectively improves space utilization of the bracket 421. In some embodiments, the axial direction of the battery 422 is arranged to intersect with the symmetry plane PL. This arrangement can effectively ensure that the axial direction of the battery 422 intersects with the horizontal plane of a human body in the wearing state, thereby effectively improving the clearance rate of the antenna assembly 10 and enhancing the antenna performance of the antenna assembly 10.

Referring to FIG. 15, the circuit board assembly 423 may include a first circuit board 425, a second circuit board 426, and a flexible circuit board 427. The flexible circuit board 427 connects the first circuit board 425 and the second circuit board 426. The circuit board (e.g., the first circuit board 425 and the second circuit board 426) is a plate-like structure of the circuit board assembly 423 for integrating circuit elements. The circuit elements may include a main control circuit, a sensor, etc. The circuit board assembly 423 may include at least one circuit board to effectively improve the integration of the circuit elements of the earphone 100, thereby ensuring functional diversity of the earphone 100 and effectively improving space utilization of the earphone 100. Circuit elements on the first circuit board 425 may be electrically connected to circuit elements on the second circuit board 426 through the flexible circuit board 427 to enable information interaction between corresponding circuit elements. In some embodiments, the circuit board assembly 423 (e.g., a circuit board) may be provided with the processing circuit 101 described in the foregoing embodiments. In some embodiments, the first circuit board 425 and/or the second circuit board 426 may be provided with the processing circuit 101 described in the foregoing embodiments.

In some embodiments, the first circuit board 425 may be arranged in the first circuit board accommodation region 4202. The second circuit board 426 may be arranged in the second circuit board accommodation region 4203. This arrangement allows the bracket 421 to provide good physical protection for the first circuit board 425 and the second circuit board 426, respectively, effectively protecting circuit elements on the circuit boards, thereby effectively reducing the risk of damage to the circuit board assembly 423 during assembly and improving the production yield of the earphone 100. The first circuit board 425 and the second circuit board 426 are arranged separately to effectively improve heat dissipation efficiency of the battery 422 and the circuit boards, thereby effectively improving operational stability of the battery 422 and the circuit elements on the circuit boards. In some embodiments, the first circuit board 425, the second circuit board 426, and the battery 422 may be arranged along the B-B direction, and the first circuit board 425 and the second circuit board 426 may be located on opposite sides of the battery 422.

In some embodiments, the first circuit board 425 and/or the second circuit board 426 are further provided with grounding points to be electrically connected to the ground line 22 (e.g., the first ground line 221 and the second ground line 222).

In some embodiments, the first circuit board 425 and/or the second circuit board 426 are further provided with radio frequency (RF) units for emitting an RF signal, allowing the first circuit board 425 and/or the second circuit board 426 to be connected to the antenna assembly 10.

In some embodiments, the first circuit board 425 is provided with the RF unit for emitting the RF signal, allowing the first circuit board 425 to be connected to the antenna assembly 10. The second circuit board 426 is further provided with a grounding point to be electrically connected to the ground line 22 (e.g., the first ground line 221 and the second ground line 222).

Referring to FIG. 15, the flexible circuit board 427 is also referred to as a flexible connection board. The flexible circuit board 427 is attached to the bracket 421. This arrangement allows the bracket 421 to support the flexible circuit board 427, effectively reducing the risk of damage to the flexible circuit board 427, thereby effectively improving the operational stability of the circuit board assembly 423.

In some embodiments, the first circuit board 425 and/or the second circuit board 426 may be flexible circuit boards.

In some embodiments, the first circuit board 425 and/or the second circuit board 426 may be rigid circuit boards.

Referring to FIG. 15, the antenna assembly 10 is arranged in the accommodation cavity. The antenna assembly 10 is connected to the RF unit that emits the RF signal, thereby enabling the transmission and reception of an antenna signal. The antenna assembly 10 may be fixed to the bracket 421 to serve as part of the assembly 42, thereby effectively improving the assembly efficiency of the earphone 100.

The antenna assembly 10 is spaced from the battery 422 by a preset distance along the axial direction of the battery 422. This arrangement can effectively improve space utilization between the battery 422 and the antenna assembly 10 and effectively reduce interference from the battery 422 to the antenna assembly 10, thereby enhancing the performance of the antenna assembly 10.

The antenna assembly 10 may include a first antenna 11 and a second antenna 12. The first antenna 11 and the second antenna 12 may be electrically connected to the RF unit, respectively, to send/receive antenna signals separately or simultaneously. This arrangement can effectively improve the operational stability and antenna performance of the antenna assembly 10.

In some embodiments, the first antenna 11 is connected to an RF port of the RF unit. The second antenna 12 is connected to ground (or connected to a grounding point). The RF unit emits or receives signals (antenna signals) simultaneously through the first antenna 11 and the second antenna 12. This configuration can effectively simplify the circuit structure between the first antenna 11, the second antenna 12, and the radio frequency unit. Furthermore, after the second antenna 12 is connected to ground, it can also serve as an antenna branch of the first antenna 11. The second antenna 12 and the first antenna 11 emit or receive signals simultaneously, thereby further improving the antenna performance of the antenna assembly 10. Moreover, after the second antenna 12 is connected to ground, it can effectively disperse the current concentrated on the first antenna 11, thereby preventing the current generated based on the RF signal from being entirely focused on the first antenna 11. This effectively reduces the Specific Absorption Ratio (SAR) value of the antenna assembly 10.

In some embodiments, the antenna structure of the first antenna 11 is the same as the antenna structure of the second antenna 12. This configuration ensures that when the relative positional relationship between the first antenna 11 and the second antenna 12 changes, the first antenna 11 or the second antenna 12 with a better clearance rate can still efficiently perform antenna functions. This effectively improves the stability of the antenna assembly 10, thereby effectively enhancing the stability of the antenna assembly 10 and maintaining consistent antenna performance when the earphone 100 is switched from one ear to the other for wearing.

In some embodiments, the first antenna 11 and the second antenna 12 are arranged at intervals along the axial direction of the battery 422. The first antenna 11 and the second antenna 12 are located on opposite sides of the battery 422. This configuration allows the first antenna 11 and the second antenna 12 to maintain a larger separation distance from the battery 422, effectively reducing interference from the battery 422 on the antenna assembly 10, thereby improving the clearance rate of the antenna assembly 10.

In some embodiments, the first antenna 11 is arranged on a side of the first circuit board 425 away from the battery 422 along the axial direction of the battery 422. The second antenna 12 is arranged on a side of the second circuit board 426 away from the battery 422 along the axial direction of the battery 422. In such cases, the first circuit board 425 and the second circuit board 426 can effectively separate the first antenna 11 and the second antenna 12 from the battery 422, respectively, which effectively reduces interference from the battery 422 on the first antenna 11 and the second antenna 12, thereby improving the operational stability and antenna performance of the antenna assembly 10.

In some embodiments, the first antenna 11 may be disposed on the first circuit board 425. The second antenna 12 may be disposed on the second circuit board 426.

Referring to FIG. 15, the capacitive detection component 20 may be disposed on the bracket 421 and serve as part of the assembly 42, thereby effectively improving the assembly efficiency of the earphone 100. In some embodiments, the capacitive detection component 20 may be located between the first circuit board 425 and the second circuit board 426. In some embodiments, the capacitive detection component 20 may be located between the first antenna 11 and the second antenna 12. In some embodiments, the capacitive detection component 20 may be arranged around at least a portion of a circumferential side wall of the battery 422. When the earphone 100 is worn by a user, at least a portion of the capacitive detection component 20 is located on a side of the circumferential side wall of the battery 422 close to the skin of the user.

It may be understood that, as long as the capacitive detection component 20 can achieve the wearing detection function of the earphone, the positional and cooperative relationships of the capacitive detection component 20 with other structures within the earphone 100 are not limited to the embodiments listed herein. Other relationships are also possible.

For example, in the assembly 42, the positional and cooperative relationships between the capacitive detection component 20 and the antenna assembly 10, the bracket 421, the battery 422, or the circuit board assembly 423 are not limited to the embodiments listed herein. Other relationships are also possible.

As another example, in the abutting portion 40, the positional relationship and cooperative relationships between the capacitive detection component 20 and the first housing assembly 41 or the assembly 42 are not limited to the embodiments listed herein. Other relationships are also possible.

As a further example, in the earphone 100, the positional and cooperative relationships between the capacitive detection component 20 and the sound-producing portion 30, the abutting portion 40, or the ear hook portion 50 are not limited to the embodiments listed herein. Other relationships are also possible.

In some embodiments, the capacitive detection component 20 may also be disposed on other portions of the earphone 100, such as the abutting portion 40 or the ear hook portion 50. In some embodiments, the capacitive detection component 20 may also be disposed on other parts of the abutting portion 40, such as the first housing assembly 41.

In FIG. 15, the capacitive detection component 20 is electrically connected to the flexible circuit board 427 to achieve electrical connection with the first circuit board 425 and/or the second circuit board 426.

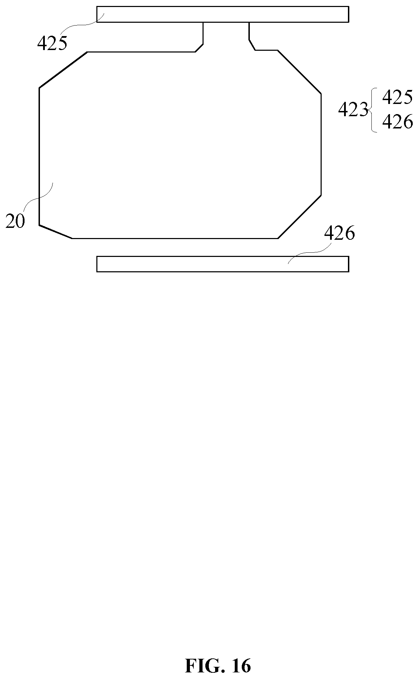

Referring to FIG. 16, FIG. 16 is a schematic diagram illustrating the first circuit board 425, the second circuit board 426, and the capacitive detection component 20 shown in FIG. 15 according to some embodiments of the present disclosure. The capacitive detection component 20 may be connected to the first circuit board 425 not through the flexible circuit board 427. Instead, a connection structure is disposed on a side of the capacitive detection component 20 facing the first circuit board 425, thereby enabling the electrical connection between the capacitive detection component 20 and the first circuit board 425.

Referring to FIG. 14, the sound-producing portion 30 includes a second housing assembly 31 and a sound-producing component (not shown) mounted inside the second housing assembly 31. The second housing assembly 31 may be connected to the ear hook portion 50. The sound-producing component is a main structure of the sound-producing portion 30. The sound-producing component is configured to implement a function of playing a sound signal to a wearer. The sound-producing component may be a sound-producing structure well-known in the art, and details are not described herein.

The foregoing descriptions are merely partial embodiments of the present disclosure. These embodiments are not intended to limit the scope of the present disclosure. Any equivalent device or equivalent process transformation based on the specification and drawings of the present disclosure, whether directly or indirectly applied in other related technical fields, shall fall within the protection scope of the present disclosure.

## Claims

1. An earphone, comprising:
an antenna assembly, and
a capacitive detection component disposed within a radiation range of the antenna assembly, and configured to generate an electrical signal based on whether a user is wearing the earphone or whether the user performs a touch action, wherein
the capacitive detection component includes a detection electrode layer and a reference electrode layer stacked together, and
at least one of the detection electrode layer or the reference electrode layer includes a serpentine trace, at least a portion of the serpentine trace being disposed in an overlapping region of the detection electrode layer and the reference electrode layer in a stacking direction.

2. The earphone of claim 1, wherein the serpentine trace includes a first serpentine trace and a second serpentine trace, the first serpentine trace being disposed in the detection electrode layer, and the second serpentine trace being disposed in the reference electrode layer.

3. The earphone of claim 2, wherein
the first serpentine trace includes a plurality of first main extension portions and a plurality of first connection portions, the plurality of first main extension portions being arranged side by side at intervals along a first direction and extending in a direction intersecting with the first direction, and the plurality of first connection portions sequentially connecting the plurality of first main extension portions;
the second serpentine trace includes a plurality of second main extension portions and a plurality of second connection portions, the plurality of second main extension portions being arranged side by side at intervals along a second direction and extending in a direction intersecting with the second direction, and the plurality of second connection portions sequentially connecting the plurality of second main extension portions; and
the first direction intersects with the second direction.

4. The earphone of claim 3, wherein the serpentine trace conforms to at least one of the following two schemes:
scheme 1: the first direction is perpendicular to the second direction.
scheme 2: the plurality of first main extension portions extend in the second direction, and the plurality of second main extension portions extend in the first direction.

5. The earphone of claim 3 or 4, wherein a line width of at least one of the first main extension portions or the second main extension portions is less than or equal to 0.3 mm.

6. The earphone of claim 3 or 4, wherein a spacing between each pair of adjacent first main extension portions and/or a spacing between each pair of adjacent second main extension portions is less than or equal to 0.5 mm.

7. The earphone of claim 6, wherein the spacing between each pair of adjacent first main extension portions is less than the spacing between each pair of adjacent second main extension portions.

8. The earphone of claim 3 or 4, wherein the reference electrode layer includes a first region and a second region, and a spacing between each pair of adjacent second main extension portions within the first region is less than a spacing between each pair of adjacent second main extension portions within the second region.

9. The earphone of claim 8, further comprising a processing circuit, wherein the reference electrode layer has a terminal electrically connected to the processing circuit, and the terminal is connected to the second main extension portions within the second region via the second main extension portions within the first region.

10. The earphone of claim 8, wherein an area of the first region is smaller than an area of the second region.

11. The earphone of claim 1, further comprising a battery, the battery being arranged in a columnar shape, the antenna assembly including a first antenna and a second antenna disposed at two ends of the battery along an axial direction of the battery at an interval, wherein
the capacitive detection component is located in an interval region between the first antenna and the second antenna, and
in a state where the user wears the earphone, at least a portion of the capacitive detection component is located on a side of a circumferential side wall of the battery close to the skin of the user, and the reference electrode layer is located between the detection electrode layer and the battery.

12. The earphone of claim 11, wherein in the state where the user wears the earphone, the axial direction of the battery intersects with a horizontal plane of a human body.

13. The earphone of claim 11 or claim 12, further comprising a first housing assembly, a second housing assembly, an ear hook portion, and a sound-producing component, wherein
the antenna assembly, the capacitive detection component, and the battery are disposed in the first housing assembly,
the sound-producing component is disposed in the second housing assembly,
the ear hook portion connects the first housing assembly and the second housing assembly, and
in the state where the user wears the earphone, the first housing assembly and the second housing assembly clamp onto two sides of a helix, the second housing assembly is located in a concha cavity, the ear hook portion has a symmetry plane along a length direction of the ear hook portion, and the axial direction of the battery intersects with the symmetry plane.
